# EUROPEAN PATENT APPLICATION

(11) **EP 4 099 565 A1**
(43) Date of publication of application: **07.12.2022**
(21) Application number: 22167574.7
(22) Date of filing: 11.04.2022
(51) Int. Cl.: H03H 9/02

(54) **SURFACE ACOUSTIC WAVE DEVICE**

(30) Priority: 01.06.2021 KR 20210071021; 01.06.2021 KR 20210071022; 23.09.2021 KR 20210125931; 23.09.2021 KR 20210125932
(71) Applicant: Wisol Co., Ltd., Osan-si, Gyeonggi-do 18103 (KR)
(72) Inventor: OH, Hae Kwan, 18103 Osan-si, Gyeonggi-do (KR); SATO, Takahiro, 18103 Osan-si, Gyeonggi-do (KR); KIHARA, Yoshikazu, 18103 Osan-si, Gyeonggi-do (KR); KIM, Tae Hyun, 18103 Osan-si, Gyeonggi-do (KR)
(74) Representative: BCKIP Part mbB

(57) **Abstract**

A surface acoustic wave device according to the present disclosure includes a support substrate (110_2); an intermediate layer laminated on the support substrate; a piezoelectric layer (130_1) laminated on the intermediate layer; and an IDT electrode formed on the piezoelectric layer, an Euler angle of the support substrate is (-45°±10°, -54°±10°, 180°±30°) and an Euler angle of the piezoelectric layer is (0°±5°, 112.5°±22.5°, 0°±5°) or (0°±5°, -67.5°+22.5°, 0°±5°). By rotating support substrate and piezoelectric layer with respect to each other, the propagation angle of the support substrate is changed allowing suppression of high frequency spurious modes.

## Description

### BACKGROUND

### Technical Field

The present disclosure relates to a surface acoustic wave device.

### Description of the Related Art

In accordance with the development of a communication industry, a wireless communication product becomes small-sized, has a higher quality, and becomes multi-functional. In accordance with this tendency, small-size and multi-functions are demanded for components used for the wireless communication product, for example, a filter and a duplexer.

As an example of such a component, a surface acoustic wave device is configured by a piezoelectric substrate which is a piezoelectric single crystal bare chip, a pair of inter digital transducer (IDT) electrodes which are formed on an upper surface of the piezoelectric substrate to be opposite to each other with a comb pattern, and an input electrode and an output electrode connected thereto.

When the surface acoustic wave device is applied with an electric signal through the input electrode, a piezoelectric distortion is caused by a piezoelectric effect as much as an overlapping electrode length between the IDT electrodes which are opposite to each other and a surface acoustic wave which is transmitted to the piezoelectric substrate is generated by the piezoelectric distortion, and is converted into an electric signal by means of the output electrode to be output.

Such a surface acoustic wave device has advantages in that it has a small size, and is easy for signal processing, and can be massively produced using a semiconductor process. Further, the surface acoustic wave device has an advantage in that the side rejection in a pass band is high so that high quality information can be exchanged.

### SUMMARY

A technical object to be achieved by the present disclosure is to provide a surface acoustic wave device which may suppress a high frequency spurious component without having a loss of a main mode.

In order to achieve the above-described technical objects, according to an aspect of the present disclosure, a surface acoustic wave device includes a support substrate; an intermediate layer laminated on the support substrate; a piezoelectric layer laminated on the intermediate layer; and an IDT electrode formed on the piezoelectric layer, an Euler angle of the support substrate is (-45°±10°, -54°±10°, 180°±30°) and an Euler angle of the piezoelectric layer is (0°±5°, 112.5°±22.5°, 0°±5°) or (0°±5°, -67.5°+22.5°, 0°±5°).

The support substrate includes silicon and the piezoelectric layer includes lithium tantalate.

The intermediate layer includes: a high acoustic velocity layer laminated on the support layer; and a low acoustic velocity layer laminated on the high acoustic velocity layer, and a acoustic velocity of a bulk wave which propagates in the high acoustic velocity layer is higher than a acoustic velocity of an elastic wave which propagates in the piezoelectric layer and a acoustic velocity of a bulk wave which propagates in the low acoustic velocity layer is lower than a acoustic velocity of an elastic wave which propagates in the piezoelectric layer.

The support substrate is formed by a substrate obtained by rotating a silicon substrate having a plane orientation <111> by 180° .

The piezoelectric layer is formed by a 42° rotated YX-cut lithium tantalate substrate.

An Euler angle of the piezoelectric layer is (0°±5°, 129.9° to 135°, 0°+5°) or (0°±5°, -50.1° to -45°, 0°±5°).

In order to achieve the above-described technical objects, according to another aspect of the present disclosure, a surface acoustic wave device includes a support substrate; an intermediate layer laminated on the support substrate; a piezoelectric layer laminated on the intermediate layer; and an IDT electrode formed on the piezoelectric layer, an Euler angle of the support substrate is (-45°±10°, -54°±10°, 0°±30°) and an Euler angle of the piezoelectric layer is (0°±5°, 112.5°±22.5°, 180°±5°) or (0°±5°, -67.5°±22.5°, 180°±5°) .

The support substrate includes silicon and the piezoelectric layer includes lithium tantalate.

The intermediate layer includes: a high acoustic velocity layer laminated on the support layer; and a low acoustic velocity layer laminated on the high acoustic velocity layer, and a acoustic velocity of a bulk wave which propagates in the high acoustic velocity layer is higher than a acoustic velocity of an elastic wave which propagates in the piezoelectric layer and a acoustic velocity of a bulk wave which propagates in the low acoustic velocity layer is lower than a acoustic velocity of an elastic wave which propagates in the piezoelectric layer.

The support substrate is formed by a silicon substrate having a plane orientation <111> by 180°.

The piezoelectric layer is formed by a substrate obtained by rotating a 42° rotated YX-cut lithium tantalate substrate by 180°.

An Euler angle of the piezoelectric layer is (0°±5°, 129.9° to 135°, 180°+5°) or (0°±5°, -50.1° to -45°, 180°±5°).

According to the present disclosure, a surface acoustic wave device which is capable of suppressing a high frequency spurious component without having a loss of a main mode can be provided.

### BRIEF DESCRIPTION OF THE DRAWINGS

FIG. 1 illustrates a cross-sectional structure of a surface acoustic wave device according to a first exemplary embodiment of the present disclosure;
FIG. 2 is a plan view of a lamination structure of a support substrate and a piezoelectric layer according to a related art;
FIG. 3 is a frequency characteristic graph of a surface acoustic wave device according to the related art;
FIG. 4 is a plan view of a lamination structure of a support substrate and a piezoelectric layer according to a first exemplary embodiment of the present disclosure;
FIG. 5 illustrates a frequency characteristic graph of a surface acoustic wave device according to a first exemplary embodiment of the present disclosure;
FIG. 6 illustrates a graph in which a frequency characteristic of FIG. 3 and a frequency characteristic of FIG. 5 overlap;
FIG. 7 illustrates wave modes of a thinned piezoelectric layer;
FIG. 8 illustrates wave modes of a result that some wave modes are eliminated by a lamination structure;
FIG. 9 illustrates a cross-sectional structure of a surface acoustic wave device according to a second exemplary embodiment of the present disclosure;
FIG. 10 is a plan view of a lamination structure of a support substrate and a piezoelectric layer according to a second exemplary embodiment of the present disclosure;
FIG. 11 illustrates a frequency characteristic graph of a surface acoustic wave device according to a second exemplary embodiment of the present disclosure; and
FIG. 12 illustrates a graph in which a frequency characteristic of FIG. 3 and a frequency characteristic of FIG. 11 overlap.

### DETAILED DESCRIPTION OF THE EMBODIMENT

Hereinafter, exemplary embodiments of the present invention will be described in detail with reference to the drawings. Substantially same components in the following description and the accompanying drawings may be denoted by the same reference numerals and redundant description will be omitted. Further, in the description of the exemplary embodiment, if it is considered that specific description of related known configuration or function may cloud the gist of the present invention, the detailed description thereof will be omitted.

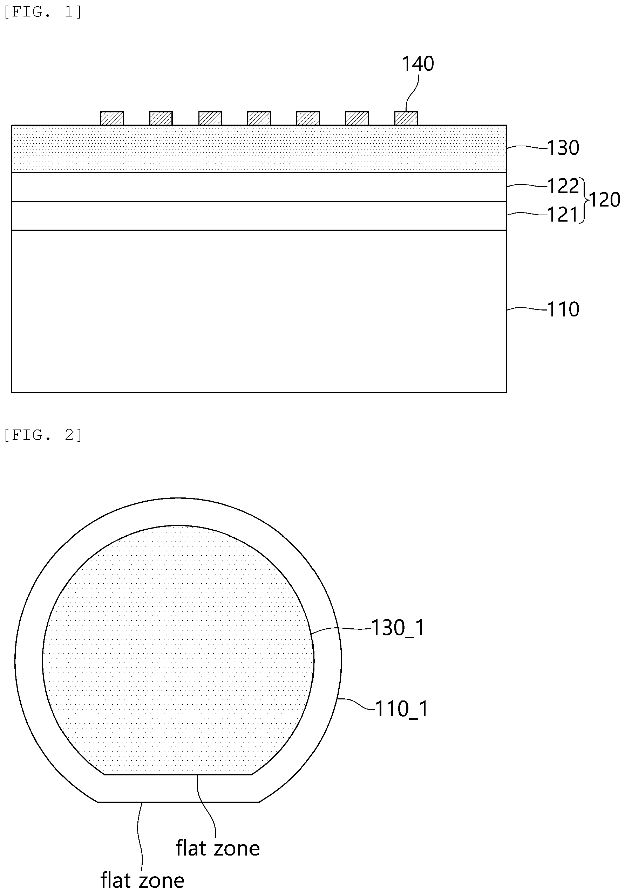

FIG. 1 illustrates a cross-sectional structure of a surface acoustic wave device according to a first exemplary embodiment of the present disclosure.

Referring to FIG. 1, a surface acoustic wave device according to an exemplary embodiment of the present disclosure includes a support substrate 110, an intermediate layer 120 laminated on the support substrate, a piezoelectric layer 130 laminated on the intermediate layer 120, and an IDT electrode 140 formed on the piezoelectric layer 130.

The support substrate 110 may be configured by at least one of a silicon (Si) material, a sapphire material, or a diamond material. A plane orientation of the support substrate 110 may be <111>, <100>, or <110> or these plane orientations may be mixed. A thickness of the support substrate 110 may be 5 µm or larger or two times a wavelength of a surface acoustic wave in consideration of a vibration of a surface acoustic wave.

The intermediate layer 120 may include a high acoustic velocity layer 121 laminated on the support substrate 110 and a low acoustic velocity layer 122 laminated on the high acoustic velocity layer 121. A acoustic velocity of a bulk wave which propagates in the high acoustic velocity layer 121 is higher than a acoustic velocity of an elastic wave which propagates in the piezoelectric layer 130. The high acoustic velocity layer 121 may be configured by material such as aluminum oxide, silicon carbide, silicon nitride, silicon oxynitride, silicon, polysilicon, sapphire, or diamond. A acoustic velocity of a bulk wave which propagates in the low acoustic velocity layer 122 is lower than a acoustic velocity of an elastic wave which propagates in the piezoelectric layer 130. The low acoustic velocity layer 122 may be configured by a material such as silicon oxide, aluminum nitride, glass, silicon oxynitride, tantalum oxide, or a compound in which fluorine, carbon, or boron is added to silicon oxide. Depending on an exemplary embodiment, the intermediate layer 120 may be configured by only any one of the high acoustic velocity layer and the low acoustic velocity layer.

The piezoelectric layer 130 may be configured by a material such as lithium tantalite (LiTaO3, LT) or lithium niobate (LiNbO3, LN), and may be a single crystal. A thickness of the piezoelectric layer 130 is not specifically limited and may be appropriately selected depending on a purpose of the surface acoustic wave device.

The interdigital transducer (IDT) electrode 140 is an electrode which is formed on an upper surface of the piezoelectric layer 130 to generate a surface acoustic wave. The IDT electrode 140 may be a single comb electrode or a double comb electrode. A material for forming the IDT electrode 140 is not specifically limited, but may be configured by Al, Al-Cu, Al-Si-Cu in terms of the processability and the cost. The thickness of the IDT electrode 140 is not specifically limited as long as it functions to vibrate the surface acoustic wave, and desirably, 10 to 500 nm. The thickness is determined in this range because when the thickness of the IDT electrode 140 is smaller than 10 nm, the resistance is increased so that the loss is increased and when the thickness exceeds 500 nm, an additional mass effect which causes the reflection of the SAW according to the thickness of the electrode is significant, which may impair a target surface acoustic wave characteristic.

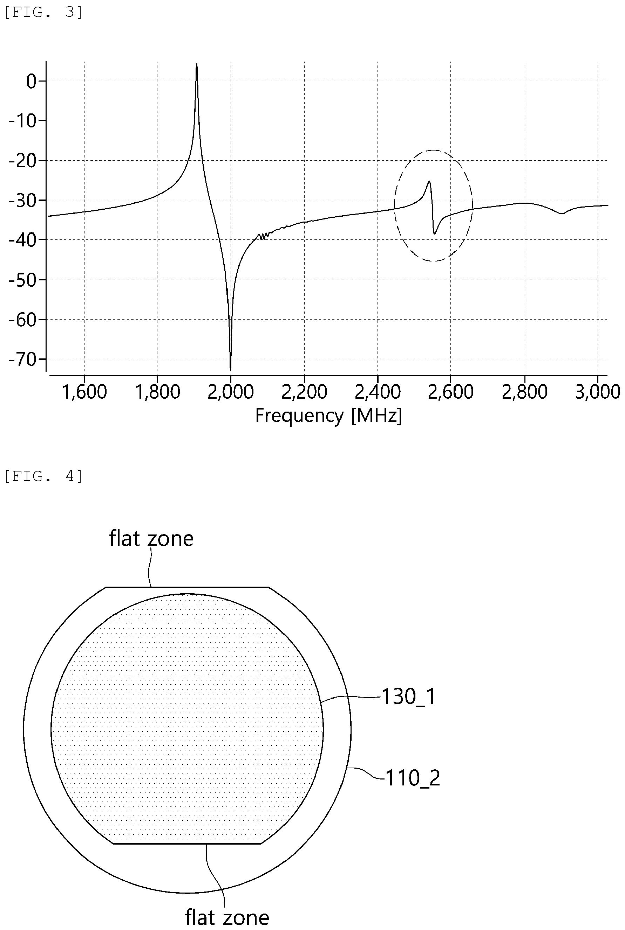

FIG. 2 is a plan view of a lamination structure of a support substrate 110 and a piezoelectric layer 130 according to a related art. In FIG. 2 (which is similar to FIG. 4 to be described below), the intermediate layer 120 is omitted for the sake of convenience. Referring to FIG. 2, the support substrate 110 is configured by a silicon substrate 110_1 having a plane orientation <111> and the piezoelectric layer 130 is formed by a 42° rotated YX-cut lithium tantalate substrate 130_1.

FIG. 3 is a frequency characteristic graph of a surface acoustic wave device according to the related art. Referring to FIG. 3, a high frequency spurious component is generated in the frequency band of approximately 2550 MHz. The high frequency spurious is generated by the coupling of high speed elastic waves generated from layers below the piezoelectric layer 130 and the piezoelectric layer 130 and may deteriorate the performance of the relative band when the duplex filter is manufactured.

FIG. 4 is a plan view of a lamination structure of a support substrate 110 and a piezoelectric layer 130 according to a first exemplary embodiment of the present disclosure. Referring to FIG. 4, the support substrate 110 is configured by a substrate 110_2 obtained by rotating a silicon substrate having a plane orientation <111> by 180° and the piezoelectric layer 130 is formed by a 42° rotated YX-cut lithium tantalate substrate 130_1.

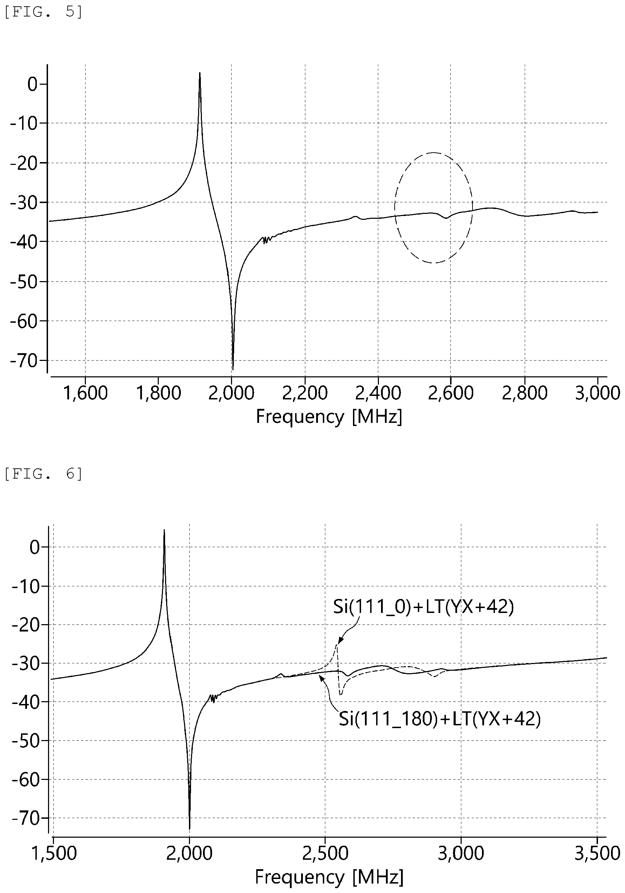

FIG. 5 illustrates a frequency characteristic graph of a surface acoustic wave device according to a first exemplary embodiment of the present disclosure. Referring to FIG. 5, it is confirmed that the high frequency spurious around approximately 2550 MHz illustrated in FIG. 3 is almost removed.

FIG. 6 illustrates a graph in which a frequency characteristic of FIG. 3 and a frequency characteristic of FIG. 5 overlap. As illustrated in the drawing, according to the first exemplary embodiment of the present disclosure, as compared with the related art, it is understood that only the high frequency spurious can be suppressed only by rotating the silicon substrate having a plane orientation <111> by 180°, without causing the loss of the main mode.

A crystal orientation of the support substrate 110 and the piezoelectric layer 130 may be expressed by an Euler angle (λ, µ, θ).

According to the first exemplary embodiment of the present disclosure, when as the support substrate 110, a substrate 110_2 obtained by rotating a silicon substrate having a plane orientation <111> by 180° is formed, the Euler angle of the support substrate 110 has a range of (-45°±10°, -54°±10°, 180°±30°), and for example, may be (-45°, -54°, 180°).

According to the first exemplary embodiment of the present disclosure, when as the piezoelectric layer 130, a 42° rotated YX-cut lithium tantalite substrate 130_1 is formed, the Euler angle of the piezoelectric layer 130 has a range of (0°±5°, 112.5°±22.5°, 0°±5°) or (0°±5°, -67.5°±22.5°, 0°±5°), and for example, may be (0°, 132°, 0°) or (0°, -48°, 0°).

Moreover, as a result of simulating a frequency characteristic while changing µ of the Euler angle (λ, µ, θ) of the piezoelectric layer 130, it is confirmed that when the µ is in the range of 129.9° to 135°, the high frequency spurious is effectively suppressed. Accordingly, to be more desirably, the Euler angle of the piezoelectric layer 130 may be in the range of (0°±5°, 129.9° to 135°, 0°±5°) or (0°±5°, -50.1° to -45°, 0°±5°).

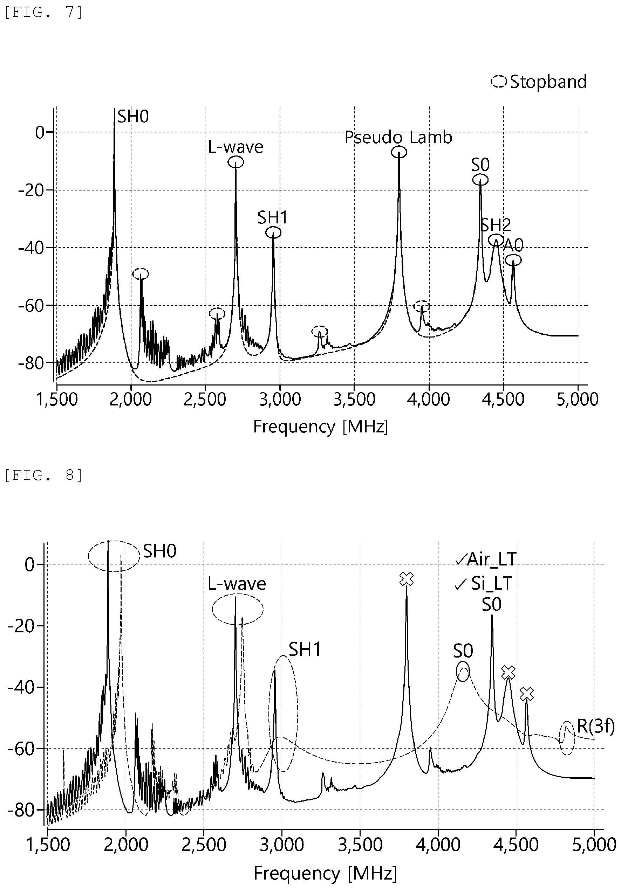

FIGS. 7 and 8 are graphs for explaining a principle of the present disclosure in which FIG. 7 illustrates wave modes of a thinned piezoelectric layer and FIG. 8 illustrates wave modes of a result that some wave modes are eliminated by a lamination structure. Each wave mode will be described as follows.
SH0 : Shear horizontal wave, main mode
L-wave : longitudinal wave
SH1 : Shear horizontal wave with different wavelength
S0 : Extensional mode, Lamb
A0 : Flexural mode, Lamb
Pseudo Lamp : longitudinal Lamb

Referring to FIG. 7, as a result of a finite element method (FEM) simulation in a structure in which the thinned LT piezoelectric layer is up in the air, it is confirmed that there are wave modes as illustrated in the drawing. Referring to FIG. 8, in the case of the structure in which the intermediate layer and the support substrate are laminated below the thinned LT piezoelectric layer, the wave modes generated by the laminated layers and the piezoelectric layer may be coupled or some wave modes are extinct. The coupled wave mode may have a speed and an amplitude different from those of the existing layer (single piezoelectric layer) due to the mechanical characteristic of each layer. Accordingly, the position and the amplitude of the wave mode may be controlled by adjusting a mechanical characteristic of a material to be laminated. Specifically, in the case of L-wave in question, the mechanical characteristic of the silicon substrate is an important variable and the mechanical characteristic of the silicon substrate is determined by the Euler angle.

The mechanical characteristic of the normal silicon substrate having plane orientations <111>, <100>, <110> is changed by changing a propagation direction, which has an effect of changing theta θ of the Euler angle (λ, µ, θ). That is, when the propagation direction of the silicon substrate having a plane orientation <111> is changed to 180°, it has the same meaning as the 180° rotation of the silicon substrate. Therefore, when the silicon substrate is rotated by 180° at the Euler angle (-45°, -54°, 0°) of the silicon substrate having a plane orientation <111>, the Euler angle becomes (-45°, -54°, 180°) .

The high frequency spurious is caused by the coupling between the piezoelectric layer and the elastic wave of the support substrate and the high frequency spurious may move or may be extinct according to the stiffness of the support substrate. The silicon used for the support substrate has different stiffness depending on the Euler angle and there is an Euler angle satisfying a condition to eliminate the L-wave of the piezoelectric layer. However, the normal silicon substrate having plane orientations <111>, <100>, <110> has a fixed Euler angle, so that it is difficult to suppress the L-wave of the piezoelectric layer. According to the first exemplary embodiment of the present disclosure, the theta θ of the Euler angle is changed by rotating (changing the propagation direction) the silicon substrate having a plane orientation <111> to suppress the L-wave of the piezoelectric layer. In addition, according to the exemplary embodiment of the present disclosure, it is advantageous to suppress the high frequency spurious without having a loss of the main mode by the combination of the normal silicon substrate and the lithium tantalate substrate.

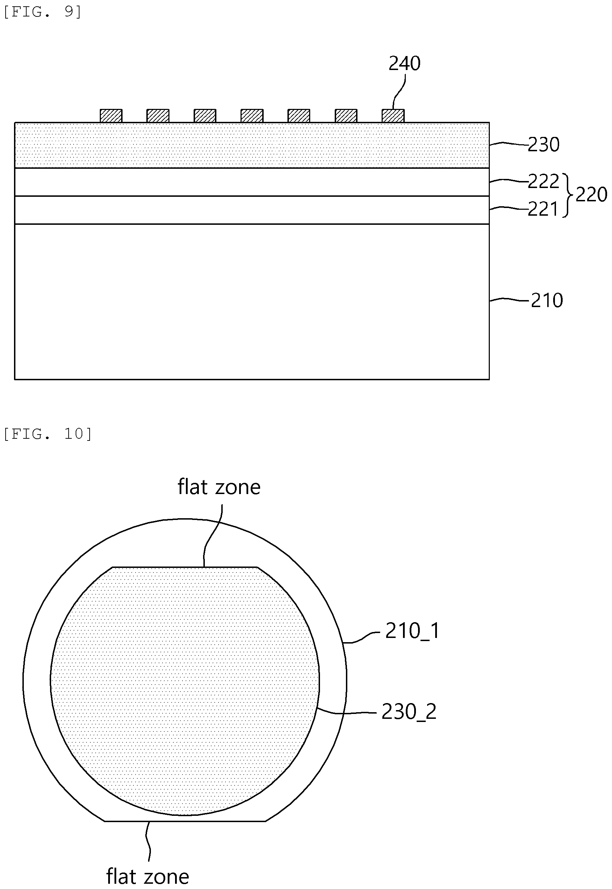

FIG. 9 illustrates a cross-sectional structure of a surface acoustic wave device according to a second exemplary embodiment of the present disclosure.

Referring to FIG. 9, a surface acoustic wave device according to an exemplary embodiment of the present disclosure includes a support substrate 210, an intermediate layer 220 laminated on the support substrate, a piezoelectric layer 230 laminated on the intermediate layer 220, and an IDT electrode 240 formed on the piezoelectric layer 230.

The support substrate 210 may be configured by at least one of a silicon (Si) material, a sapphire material, or a diamond material. A plane orientation of the support substrate 210 may be <111>, <100>, or <110> or these plane orientations may be mixed. A thickness of the support substrate 210 may be 5 µm or larger or two times a wavelength of a surface acoustic wave in consideration of a vibration of a surface acoustic wave.

The intermediate layer 220 may include a high acoustic velocity layer 221 laminated on the support substrate 210 and a low acoustic velocity layer 221 laminated on the high acoustic velocity layer 222. A acoustic velocity of a bulk wave which propagates in the high acoustic velocity layer 221 is higher than a acoustic velocity of an elastic wave which propagates in the piezoelectric layer 230. The high acoustic velocity layer 221 may be configured by aluminum oxide, silicon carbide, silicon nitride, silicon oxynitride, silicon, polysilicon, sapphire, or diamond. A acoustic velocity of a bulk wave which propagates in the low acoustic velocity layer 222 is lower than a acoustic velocity of an elastic wave which propagates in the piezoelectric layer 230. The low acoustic velocity layer 222 may be configured by a material such as silicon oxide, aluminum nitride, glass, silicon oxynitride, tantalum oxide, or a compound in which fluorine, carbon, or boron is added to silicon oxide. Depending on an exemplary embodiment, the intermediate layer 220 may be configured by only any one of the high acoustic velocity layer and the low acoustic velocity.

The piezoelectric layer 230 may be configured by a material such as lithium tantalite (LiTaO3, LT) or lithium niobate (LiNbO3, LN), and may be a single crystal. A thickness of the piezoelectric layer 230 is not specifically limited and may be appropriately selected depending on a purpose of the surface acoustic wave device.

The interdigital transducer (IDT) electrode 240 is formed on an upper surface of the piezoelectric layer 230 to generate a surface acoustic wave. The IDT electrode 240 may be a single comb electrode or a double comb electrode. A material for forming the IDT electrode 240 is not specifically limited, but may be configured by Al, Al-Cu, Al-Si-Cu in terms of the processability and the cost. The thickness of the IDT electrode 240 is not specifically limited as long as it functions to vibrate the surface acoustic wave, and desirably, 10 to 500 nm.

FIG. 10 is a plan view of a lamination structure of a support substrate 210 and a piezoelectric layer 230 according to a second exemplary embodiment of the present disclosure. Referring to FIG. 10, the support substrate 210 is configured by a silicon substrate 210_1having a plane orientation <111> and the piezoelectric layer 230 is formed by a substrate 230_2 obtained by rotating a 42° rotated YX-cut lithium tantalate substrate 230_1 by 180°.

According to the first exemplary embodiment, the support substrate 110 is formed by the substrate 110_2 obtained by rotating the silicon substrate having a plane orientation <111> by 118°, but according to the second exemplary embodiment, the piezoelectric layer 230 is formed by a substrate 230_2 obtained by rotating a 42° rotated YX-cut lithium tantalate substrate by 180°. According to the second exemplary embodiment, when the lithium tantalate substrate is rotated and the substrate 210 uses the silicon substrate 210_1 having a plane orientation <111> as in the related art, as compared with the first exemplary embodiment, there is a manufacturing advantage. In order to easily perform the exposure process during the process of manufacturing the surface acoustic wave, it is desirable that a flat zone of the support substrate is not changed. However, when the silicon substrate is rotated, the position of the flat zone is changed (see FIGS. 2 and 4), so that it is difficult to perform the exposure process. According to the second exemplary embodiment, the flat zone of the silicon substrate 210_1 is located as it is (see FIGS. 2 and 10) and only the flat zone of the lithium tantalate substrate is changed so that it is easy to perform the exposure process.

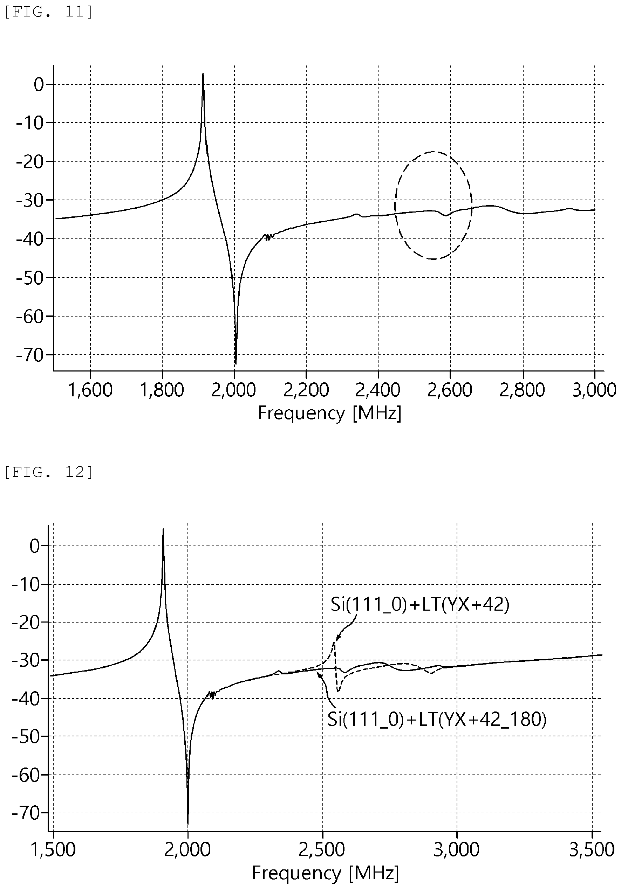

FIG. 11 illustrates a frequency characteristic graph of a surface acoustic wave device according to a second exemplary embodiment of the present disclosure. Referring to FIG. 11, it is confirmed that the high frequency spurious around approximately 2550 MHz illustrated in FIG. 3 is almost removed.

FIG. 12 illustrates a graph in which a frequency characteristic of FIG. 3 and a frequency characteristic of FIG. 11 overlap. As illustrated in the drawing, according to the exemplary embodiment of the present disclosure, as compared with the related art, it is understood that only the high frequency spurious can be suppressed only by rotating the 42° rotated YX cut lithium tantalate substrate by 180°, without causing the loss of the main mode.

A crystal orientation of the support substrate 210 and the piezoelectric layer 230 may be expressed by Euler angles (λ, µ, θ).

As described in the second exemplary embodiment of the present disclosure, when the support substrate 210 is formed by a silicon substrate 210_1 having a plane orientation <111>, the Euler angle of the support substrate 210 has a range of (-45°±10°, -54°±10°, 0°±30°), and for example, may be (-45°, -54°, 0°).

According to the second exemplary embodiment of the present disclosure, when as the piezoelectric layer 230, a substrate 230_2 formed by rotating the 42° rotated YX-cut lithium tantalite substrate by 180° is formed, the Euler angle of the piezoelectric layer 230 has a range of (0°±5°, 112.5°±22.5°, 180°±5°) or (0°±5°, -67.5°±22.5°, 180°±5°), and for example, maybe (0°, 132°, 180°) or (0°, -48°, 180°) .

Moreover, as a result of simulating a frequency characteristic while changing µ of the Euler angle (λ, µ, θ) of the piezoelectric layer 230, it is confirmed that when the µ is in the range of 129.9° to 135°, the high frequency spurious is effectively suppressed. Accordingly, to be more desirably, the Euler angle of the piezoelectric layer 230 may be in the range of (0°±5°, 129.9° to 135°, 180°±5°) or (0°±5°, -50.1° to -45°, 180°±5°).

The mechanical characteristic of the normal 42° rotated YX-cut lithium tantalate substrate is changed by changing a propagation direction, which has an effect of changing theta θ of the Euler angle (λ, µ, θ). That is, the 180° changing of the propagation direction of the 42° rotated YX-cut lithium tantalate substrate is the same meaning as the 180° rotation of the lithium tantalate substrate. Therefore, when the lithium tantalate substrate is rotated by 180° at the Euler angle (0°, 132°, 0°) of the 42° rotated YX-cut lithium tantalate substrate, the Euler angle becomes (0°, 132°, 180°).

The high frequency spurious is caused by the coupling between the piezoelectric layer and the elastic wave of the support substrate and the high frequency spurious may move or may be eliminated according to the stiffness of the piezoelectric layer and the support substrate. The lithium tantalate used for the piezoelectric layer has different stiffness depending on the Euler angle and there is an Euler angle satisfying a condition that the generated L-wave is coupled with a wave of the silicon support substrate having a plane orientation <111> to be extinct. However, the normal 42° rotated YX-cut lithium tantalate substrate has a fixed Euler angle, so that it is difficult to suppress the L-wave of the piezoelectric layer. According to the second exemplary embodiment of the present disclosure, the theta θ of the Euler angle is changed by rotating (changing the propagation direction) the 42° rotated YX-cut lithium tantalate substrate to suppress the L-wave of the piezoelectric layer. In addition, according to the exemplary embodiment of the present disclosure, it is advantageous to suppress the high frequency spurious without having a loss of the main mode by the combination of the normal silicon substrate and the lithium tantalate substrate.

For now, the present disclosure has been described with reference to the exemplary embodiments. It is understood to those skilled in the art that the present disclosure may be implemented as a modified form without departing from an essential characteristic of the present disclosure. Therefore, the disclosed exemplary embodiments may be considered by way of illustration rather than limitation. The scope of the present disclosure is presented not in the above description but in the claims and it may be interpreted that all differences within an equivalent range thereto may be included in the present disclosure.

## Claims

1. A surface acoustic wave device, comprising:
a support substrate;
an intermediate layer laminated on the support substrate;
a piezoelectric layer laminated on the intermediate layer; and
an IDT electrode formed on the piezoelectric layer,
wherein an Euler angle of the support substrate is (-45°±10°, -54°±10°, 180°±30°) and an Euler angle of the piezoelectric layer is (0°±5°, 112.5°±22.5°, 0°±5°) or (0°±5°, -67.5°±22.5°, 0°±5°).

2. The surface acoustic wave device according to claim 1, wherein the support substrate includes silicon and the piezoelectric layer includes lithium tantalate.

3. The surface acoustic wave device according to claim 1 or 2, wherein the intermediate layer includes:
a high acoustic velocity layer laminated on the support layer; and
a low acoustic velocity layer laminated on the high acoustic velocity layer, and
a acoustic velocity of a bulk wave which propagates in the high acoustic velocity layer is higher than a acoustic velocity of an elastic wave which propagates in the piezoelectric layer and a acoustic velocity of a bulk wave which propagates in the low acoustic velocity layer is lower than a acoustic velocity of an elastic wave which propagates in the piezoelectric layer.

4. The surface acoustic wave device according to any one of claims 1 to 3, wherein the support substrate is formed by a substrate obtained by rotating a silicon substrate having a plane orientation <111> by 180°.

5. The surface acoustic wave device according to any one of claims 1 to 4, wherein the piezoelectric layer is formed by a 42° rotated YX-cut lithium tantalate substrate.

6. The surface acoustic wave device according to any one of claims 1 to 5, wherein an Euler angle of the piezoelectric layer is (0°+5°, 129.9° to 135°, 0°+5°) or (0°±5°, -50.1° to -45°, 0°±5°).

7. A surface acoustic wave device, comprising:
a support substrate;
an intermediate layer laminated on the support substrate;
a piezoelectric layer laminated on the intermediate layer; and
an IDT electrode formed on the piezoelectric layer,
wherein an Euler angle of the support substrate is (-45°±10°, -54°±10°, 0°±30°) and an Euler angle of the piezoelectric layer is (0°+5°, 112.5°±22.5°, 180°±5°) or (0°±5°, -67.5°±22.5°, 180°±5°).

8. The surface acoustic wave device according to claim 7, wherein the support substrate includes silicon and the piezoelectric layer includes lithium tantalate.

9. The surface acoustic wave device according to claim 7 or 8, wherein the intermediate layer includes:
a high acoustic velocity layer laminated on the support layer; and
a low acoustic velocity layer laminated on the high acoustic velocity layer, and
a acoustic velocity of a bulk wave which propagates in the high acoustic velocity layer is higher than a acoustic velocity of an elastic wave which propagates in the piezoelectric layer and a acoustic velocity of a bulk wave which propagates in the low acoustic velocity layer is lower than a acoustic velocity of an elastic wave which propagates in the piezoelectric layer.

10. The surface acoustic wave device according to any one of claims 7 to 9, wherein the support substrate is formed by a silicon substrate having a plane orientation <111>.

11. The surface acoustic wave device according to any one of claims 7 to 10, wherein the piezoelectric layer is formed by a substrate obtained by rotating a 42° rotated YX-cut lithium tantalate substrate by 180°.

12. The surface acoustic wave device according to any one of claims 7 to 11, wherein an Euler angle of the piezoelectric layer is (0°±5°, 129.9° to 135°, 180°±5°) or (0°±5°, -50.1° to -45°, 180°±5°).
